# EUROPÄISCHE PATENTSCHRIFT

(11) **EP 3 351 061 B1**
(45) Veröffentlichungstag und Bekanntmachung des Hinweises auf die Patenterteilung: **06.10.2021**
(21) Anmeldenummer: 16760404.0
(22) Anmeldetag: 18.08.2016
(51) Int. Cl.: H05K 1/14, H05K 3/36, H05K 5/00

(54) **ELEKTRONISCHE BAUGRUPPE FÜR EIN GETRIEBESTEUERMODUL**
ELECTRONIC ASSEMBLY FOR A TRANSMISSION CONTROL MODULE
BLOC ÉLECTRONIQUE POUR MODULE DE COMMANDE DE TRANSMISSION

(30) Priorität: 17.09.2015 DE 102015217802
(43) Veröffentlichungstag der Anmeldung: 25.07.2018
(73) Patentinhaber: Robert Bosch GmbH, 70442 Stuttgart (DE)
(72) Erfinder: WALDENMEIER, Steffen, 75249 Kieselbronn (DE); LISKOW, Uwe, 71679 Asperg (DE); WEISS, Markus, 73760 Ostfildern (DE); KOWATSCH, Martin, 74343 Hohenhaslach (DE)
(86) Internationale Anmeldenummer: PCT/EP2016/069646
(87) Internationale Veröffentlichungsnummer: WO 2017/045860

(56) Entgegenhaltungen:
- WO-A1-2015/004830
- DE-A1- 3 812 922
- DE-C1- 19 751 095
- US-A- 3 646 670
- US-A- 5 526 563
- US-A1- 2007 169 559

## Beschreibung

### Stand der Technik

Die Erfindung betrifft eine elektronische Baugruppe, insbesondere für ein Getriebesteuermodul, mit den Merkmalen des Oberbegriffs des unabhängigen Anspruchs 1.

In der Kraftfahrzeugtechnik werden zur Getriebeansteuerung am Getriebe verbaute elektronische Steuermodule verwendet. Die Leiterplatten der Steuermodule können Aktuatoren, Sensoren, Stecker, wenigstens ein gekapseltes Steuergerät (TCU, Transmission Control Unit) und weitere Komponenten aufweisen. Die Leiterplatten sind über elektrische Anschlusselemente mit außerhalb der Leiterplatten angeordneten elektrischen oder elektronischen Komponenten, beispielsweise Sensoren, Aktuatoren und Steckerteilen, elektrisch kontaktiert. Die Anschlusselemente können beispielsweise Kabel oder Stanzgitter sein. Eine besondere Bedeutung kommt dabei flexiblen Leiterplatten als Anschlusselement für Leiterplatten zu.

Eine gängige Verbundanordnung einer Grundleiterplatte und einer flexiblen Leiterplatte als Anschlusselement zeigt beispielsweise die DE 10 2011 003 570 A1. In dieser Schrift ist eine an einer Kontaktstelle elektrisch leitend mit Kontaktstellen einer flexiblen Leiterplatte verbundene starre Grundleiterplatte offenbart, wobei die starre Grundleiterplatte und die flexible Leiterplatte durch eine Lötverbindung elektrisch und mechanisch miteinander verbunden sind.

US5526563 A offenbart den Oberbegriff des Anspruchs 1.

### Offenbarung der Erfindung

Erfindungsgemäß wird eine elektronische Baugruppe, für ein Getriebesteuermodul entsprechend Anspruch 1 vorgeschlagen.

### Vorteile der Erfindung

Gegenüber dem Stand der Technik weist die erfindungsgemäße elektronische Baugruppe den Vorteil auf, dass das in dem Zwischenraum zwischen der zweiten Seite der Grundleiterplatte und der Kontaktseite der flexiblen Leiterplatte angeordnete Verbindungsmittel durch die das Verbindungsmittel in dem Zwischenraum umlaufend umgebende fleißfähige und aushärtbare Klebemasse vor äußeren Einflüssen wie beispielsweise umgebenden Medien wie Öl, Spänen, oder mechanischen Belastungen geschützt ist und das Verbindungsmittel nach außen hin abgedichtet ist. Darüber hinaus kann die flexible Leiterplatte nicht nur über das Verbindungsmittel, sondern zusätzlich vorteilhaft durch die fließfähige und aushärtbare Klebemasse mit der Grundleiterplatte verbunden sein. So kann die flexible Leiterplatte vorteilhaft stabil mit der Grundleiterplatte verbunden sein. Desweiteren wird durch die erfindungsgemäße elektronische Baugruppe eine parallele Anordnung der flexiblen Leiterplatte zur Grundleiterplatte erleichtert und Hohlräume in dem Zwischenraum zwischen der zweiten Seite der Grundleiterplatte und der Innenseite der flexiblen Leiterplatte können vorteilhaft von der fleißfähigen und aushärtbaren Klebemasse ausgefüllt sein. Die Kontaktierungsstellen können durch die zusätzliche Verbindung der Grundleiterplatte und der flexiblen Leiterplatte durch die fließfähige und aushärtbare Klebemasse bei der erfindungsgemäßen elektronischen Baugruppe auch beispielsweise vorteilhaft nahe am Rand der flexiblen Leiterplatte oder nahe am Rand der Grundleiterplatte angeordnet sein, was besonders vorteilhafte kompakte Bauformen der elektronischen Baugruppe ermöglicht.

Weitere vorteilhafte Ausgestaltungen und Weiterbildungen der Erfindung werden durch die in den Unteransprüchen angegebenen Merkmale ermöglicht.

Das elektrisch leitfähige Verbindungsmittel haftet stoffschlüssig an der auf der zweiten Seite der der Grundleiterplatte angeordneten Kontaktierungsstelle und/oder an der auf der Kontaktseite der flexiblen Leiterplatte angeordneten weiteren Kontaktierungsstelle an, wobei das Verbindungsmittel ein Lot ist. Dies hat den Vorteil, dass neben der elektrisch leitenden Verbindung auch eine stoffschlüssige mechanische Verbindung des Verbindungsmittels mit der auf der zweiten Seite der Grundleiterplatte angeordneten Kontaktierungsstelle und/oder mit der auf der Kontaktseite der flexiblen Leiterplatte angeordneten weiteren Kontaktierungsstelle hergestellt ist, so dass das Befestigungsmittel vorteilhaft an der Grundleiterplatte und/oder der flexiblen Leiterplatte mechanisch befestigt ist.

Die flexible Leiterplatte umfasst eine flexible Basisfolie, die Epoxidharz und Glasfasern aufweist, wenigstens eine auf der flexiblen Basisfolie angeordnete Leiterbahn und eine die wenigstens eine Leiterbahn zumindest teilweise abdeckende Schutzschicht oder Schutzfolie, wobei die aushärtbare Klebemasse zumindest bereichsweise stoffschlüssig an der flexiblen Basisfolie anhaftet. Dies hat den Vorteil, dass die flexible Leiterplatte vorteilhaft einfach aus dem gleichen Grundmaterial wie die Grundleiterplatte gefertigt sein kann. Durch die Verwendung von Epoxidharz als Material für die flexible Leiterplatte kann die fließfähige und aushärtbare Klebemasse vorteilhaft an der flexiblen Leiterplatte besonders gut anhaften, wodurch eine machnisch stabile Verbindung entsteht und das Verbindungsmittel vorteilhaft sicher durch die fließfähige und aushärtbare Klebemasse vor äußeren Einwirkungen geschützt wird. Außerdem weisen die Grundleiterplatte und die aus gleichem Material gefertigte flexible Leiterplatte in diesem vorteilhaften Ausführungsbeispiel ähnliches oder gleiches Wärmeausdehnungsverhalten auf, so dass thermomechanische Spannungen in der elektronischen Baugruppe vorteilhaft vermieden werden können.

Da darüber hinaus die die wenigstens eine Leiterbahn zumindest teilweise abdeckende Schutzschicht oder Schutzfolie zumindest teilweise aus Epoxidharz hergestellt ist, ergibt sich der Vorteil, dass die fließfähige und aushärtbare Klebemasse zusätzlich sicher und fest an der Schutzschicht oder Schutzfolie anhaften kann.

Besonders vorteilhaft ist die fließfähige und aushärtbare Klebemasse niedrigviskos. So kann fließfähige und aushärtbare Klebemasse im noch nicht ausgehärteten Zustand vorteilhaft in Aussparungen und Zwischenräume der elektronischen Baugruppe fließen und anschließend in diesen ausgehärtet werden, so dass diese Aussparungen und Zwischenräume von der fleißfähigen und aushärtbaren Klebemasse ausgefüllt sind und von der fleißfähigen und aushärtbaren Klebemasse umgebene Elemente, wie beispielsweise das Verbindungsmittel, vorteilhaft und sicher durch die fließfähige und aushärtbare Klebemasse geschützt werden.

Die Klebemasse ist zumindest teilweise aus einem Epoxidgießharz gefertigt. Deshalb kann die fließfähige und aushärtbare Klebemasse vorteilhaft an der beispielsweise aus dem gleichen Material gefertigten Grundleiterplatte und/oder der ein Epoxidharz umfassenden flexiblen Leiterplatte oder der zumindest teilweise aus Epoxidharz hergestellten Schutzschicht oder Schutzfolie anhaften. Durch das Material kann vorteilhaft eine besonders vorteilhafte starke Verbindung zwischen den Bauteilen hergestellt werden. Außerdem können so thermische Spannungen in der elektronischen Baugruppe vorteilhaft minimiert werden, da die fleißfähige und aushärtbare Klebemasse beispielsweise vorteilhaft ein ähnliches Wärmeausdehnungsverhalten wie die Grundleiterplatte, die flexible Leiterplatte oder die Schutzschicht oder Schutzfolie aufweisen kann.

In einem besonders vorteilhaften Ausführungsbeispiel ist die flexible Leiterplatte zumindest in dem Bereich, in dem sie durch den Zwischenraum von der Grundleiterplatte beabstandet ist, parallel zur Grundleiterplatte angeordnet. Eine derartige Anordnung ist vorteilhaft kompakt und kann das Verbindungsmittel vorteilhaft vor äußeren Einwirkungen und Belastungen schützen.

Besonders vorteilhaft ist in der flexiblen Leiterplatte wenigstens ein Kanal ausgebildet, der die Kontaktseite der flexiblen Leiterplatte im Bereich des Zwischenraums mit einer von der Kontaktseite abgewandten Außenseite der flexiblen Leiterplatte verbindet und der zumindest teilweise mit der Klebemasse gefüllt ist. Der Klebstoff kann sich durch Kapillarwirkung an den Innenwänden des Kanals hochziehen. Der Kanal kann so beispielsweise vorteilhaft als Ausgaskanal für in Aussparungen und Zwischenräumen im Zwischenraum befindliche Gase oder beispielsweise auch vorteilhaft zur optischen Kontrolle, ob sich die fleißfähige und aushärtbare Klebemasse verteilt hat, dienen.

Weiterhin vorteilhaft ist ein Verfahren zur Herstellung der elektronischen Baugruppe, insbesondere für ein Getriebesteuermodul.

### Kurze Beschreibung der Zeichnungen

Ausführungsbeispiele der Erfindung sind in der Zeichnung dargestellt und werden in der nachfolgenden Beschreibung näher erläutert. Es zeigen
Fig. 1a einen Querschnitt durch ein erstes Ausführungsbeispiel der erfindungsgemäßen elektronischen Baugruppe,
Fig. 1b einen Querschnitt durch das erste Ausführungsbeispiel der erfindungsgemäßen elektronischen Baugruppe in vereinfachter Form,
Fig. 2 einen Querschnitt durch ein zweites Ausführungsbeispiel der erfindungsgemäßen elektronischen Baugruppe,
Fig. 3 einen Querschnitt durch ein drittes Ausführungsbeispiel der erfindungsgemäßen elektronischen Baugruppe.

### Ausführungsformen der Erfindung

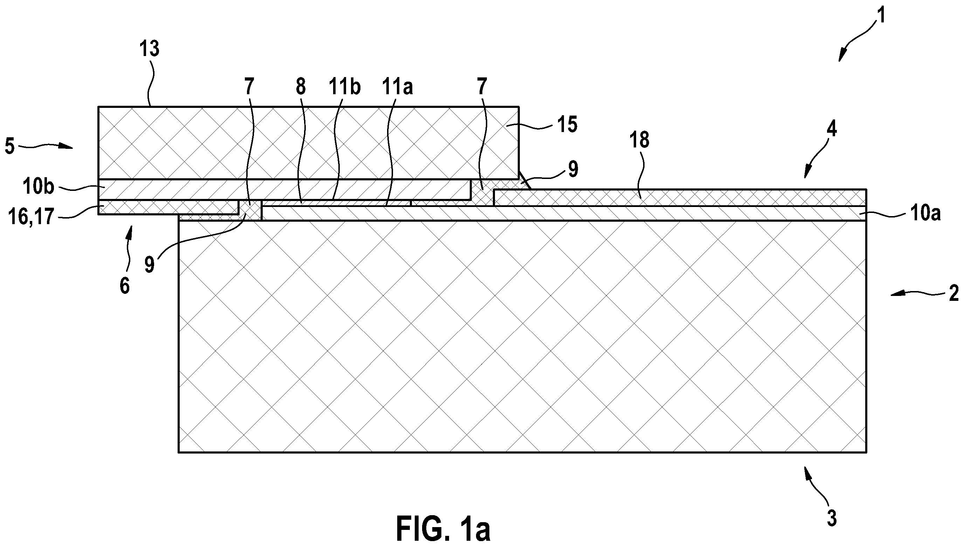

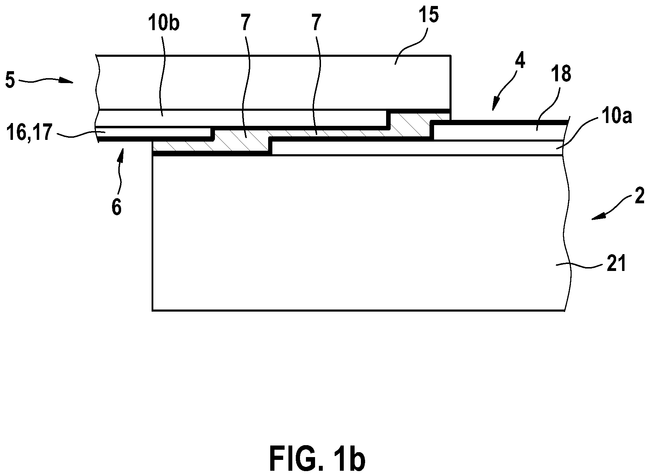

Fig. 1 zeigt einen Querschnitt durch ein erstes Ausführungsbeispiel der erfindungsgemäßen elektronischen Baugruppe 1, insbesondere für ein Getriebesteuermodul. Die elektronische Baugruppe 1 umfasst eine Grundleiterplatte 2 mit einer ersten Seite 3 und einer von der ersten Seite 3 abgewandten zweiten Seite 4. In diesem Ausführungsbeispiel handelt es sich bei der Grundleiterplatte 2 um eine starre Leiterplatte, beispielsweise um eine Leiterplatte in FR4-Ausführung oder höherwertig, also beispielsweise um eine Leiterplatte aus glasfaserverstärktem Epoxidharz als Trägermaterial von Leiterbahnen. Die Grundleiterplatte 2 kann aber auch eine HDI-Leiterplatte (High Density Interconnect-Leiterplatte), eine LTCC (Low Temperature Cofired Ceramics) oder eine andere geeignete starre Leiterplatte sein. In diesem Ausführungsbeispiel weist die Grundleiterplatte 2 wenigstens eine Leiterbahn 10a auf und auf der zweiten Seite 4 der Grundleiterplatte 2 ist eine elektrisch mit der Leiterbahn 10a verbundene Kontaktierungsstelle 11a vorgesehen. Die Leiterbahn 10a und die Kontaktierungsstelle 11a sind dabei beispielsweise einteilig aus elektrisch leitendem Metall gefertigt, in diesem Ausführungsbeispiel beispielsweise aus Kupfer. Die Leiterbahn 10a ist in diesem Ausführungsbeispiel in Bereichen, in denen sie nicht mit anderen Bauelementen kontaktiert werden soll, von einer Schicht 18 des Materials der Grundleiterplatte 2 oder einem anderen Abdeckmaterial, beispielsweise einem Lack, bedeckt, so dass sie beispielsweise vor äußeren Einwirkungen geschützt und gegenüber anderen, außerhalb der Baugruppe angeordneten, elektrisch leitenden und in Fig. 1 nicht dargestellten Bauelementen elektrisch isoliert ist. Die Grundleiterplatte 2 kann natürlich auch eine Vielzahl von Leiterbahnen 10a aufweisen und insbesondere auch als Mehrlagenleiterplatte ausgebildet sein. An der Kontaktierungsstelle 11a ist die Leiterbahn 10a in diesem Ausführungsbeispiel freigelegt. In diesem Ausführungsbeispiel umfasst die Leiterbahn 10a die Kontaktierungsstelle, die beispielsweise ein Ende der Leiterbahn 10a bilden kann. Die Kontaktierungsstelle 11a der Leiterbahn 10a kann aber beispielsweise auch als Anschlusspunkt auf der zweiten Seite 4 der Grundleiterplatte 2 ausgebildet sein und mit einer verdeckten, beispielsweise im Inneren der Grundleiterplatte 2 angeordneten Leiterbahn 10a beispielsweise durch elektrisch leitende Vias elektrisch leitend verbunden sein.

Die elektronische Baugruppe 1 umfasst weiterhin eine flexible Leiterplatte 5. Die flexible Leiterplatte 5 umfasst in diesem Ausführungsbeispiel eine flexible Basisfolie 15, die Epoxidharz und Glasfasern aufweist und wenigstens eine auf der flexiblen Basisfolie 15 angeordnete weitere Leiterbahn 10b. Die auf der flexiblen Basisfolie 15 angeordnete weitere Leiterbahn 10b kann beispielsweise aus einem elektrisch leitenden Metall, beispielsweise aus Kupfer gefertigt sein. Die flexible Leiterplatte kann natürlich auch eine Vielzahl an weiteren Leiterbahnen 10b aufweisen. In den Ausführungsbeispielen ist immer nur eine Leiterbahn dargestellt.

Des Weiteren umfasst die flexible Leiterplatte 5 eine die wenigstens eine weitere Leiterbahn 10b zumindest teilweise abdeckende Schutzschicht 16 oder Schutzfolie 17. Die Schutzschicht 16 oder die Schutzfolie 17 kann besteht teilweise oder vollständig aus Epoxidharz und so in den Zwischenräumen zwischen den Leiterbahnen 10b mit der Basisfolie 15, die beispielsweise ebenfalls zumindest teilweise aus Epoxidharz bestehen kann, eine stoffschlüssige Verbindung eingehen, so dass die von der Schutzschicht 16 oder der Schutzfolie 17 abgedeckte weitere Leiterbahn 10b durch die Schutzschicht 16 oder die Schutzfolie 17 vor äußeren Einwirkungen geschützt und beispielsweise auch vor außerhalb der erfindungsgemäßen elektronischen Baugruppe 1 angeordneten elektrisch leitenden und in der Fig. 1 nicht dargestellten Bauelementen elektrisch isoliert ist. Die Schutzschicht 16 kann beispielsweise ein Schutzlack sein. Die weitere Leiterbahn 10b ist in diesem Ausführungsbeispiel beispielsweise an einem Ende nicht von der Schutzschicht 16 oder der Schutzfolie 17 bedeckt, so dass in diesem Ausführungsbeispiel dieses nicht von der Schutzschicht 16 oder von der Schutzfolie 17 bedeckte Ende der weiteren Leiterbahn 10b eine freiliegende weitere Kontaktierungsstelle 11b bildet, über die die weitere Leiterbahn 10b der flexiblen Leiterplatte 5 beispielsweise elektrisch kontaktiert werden kann. Ist die Schutzschicht 16 oder die Schutzfolie 17 beispielsweise zumindest teilweise aus Epoxidharz hergestellt, können die Schutzschicht 16 oder die Schutzfolie 17 beispielsweise auch flächig die gesamte Kontaktseite der flexiblen Leiterplatte bedecken und nur Aussparungen an Stellen, an denen beispielsweise darunterliegende weitere Leiterbahnen 10b elektrisch leitend kontaktiert werden sollen, aufweisen. Die Schutzschicht 16 oder die Schutzfolie 17 kann aber auch beispielsweise auch mehrteilig ausgebildet sein und beispielsweise nur an ausgewählten Stellen die weitere Leiterbahn 10b bedecken.

In dem in Fig. 1 dargestellten ersten Ausführungsbeispiel sind die Grundleiterplatte 2 und die flexible Leiterplatte 5 derart zueinander angeordnet, dass eine der zweiten Seite 4 der Grundleiterplatte 2 zugewandte Kontaktseite 6 der flexible Leiterplatte 5 abschnittsweise von der Grundleiterplatte 2 durch wenigstens einen Zwischenraum 7 beabstandet ist. Dazu sind die Grundleiterplatte 2 und die flexible Leiterplatte 5 in diesem Ausführungsbeispiel beispielsweise parallel angeordnet. Die Kontaktseite 6 der flexiblen Leiterplatte 5 und die zweite Seite 4 der Grundleiterplatte 2 sind dabei beispielsweise, wie in diesem Ausführungsbeispiel dargestellt, an ihren Rändern oder an anderen Orten durch den Zwischenraum 7 beabstandet. Fig. 1b zeigt zur besseren Übersicht die geometrischen Verhältnisse in einer vergrößerten Darstellung. Zur besseren Übersicht wurde in Fig. 1b das elektrisch leitfähige Verbindungsmittel 8 und die fließfähige und aushärtbare Klebemasse 9 weggelassen. Die gesamte Kontaktseite 6 der flexiblen Leiterplatte 5 ist in Fig. 1b durch Fettdruck hervorgehoben. Ebenso ist die zweite Seite 4 der Leiterplatte 2 in Fig. 1b durch Fettdruck hervorgehoben. Der Zwischenraum 7 wird durch den gesamten schraffiert dargestellten Raum zwischen der fettgedruckten Kontaktseite 6 und der fettgedruckten zweiten Seite 4 der Leiterplatte 2 gebildet. In diesem Ausführungsbeispiel liegen sich beispielsweise eine Kontaktierungsstelle 11a der Grundleiterplatte 2 und eine Kontaktierungsstelle 11b der flexiblen Leiterpatte 5 durch einen Zwischenraum 5 getrennt gegenüber. Die flexible Leiterplatte 5 kann beispielsweise auch gebogen sein, so dass beispielsweise nur der durch den Zwischenraum 5 von der zweiten Seite 4 der Grundleiterplatte 2 beabstandete Bereich der flexiblen Leiterplatte 5 planparallel zu der Grundleiterplatte 2 angeordnet ist.

In diesem Ausführungsbeispiel ist die weitere Kontaktierungsstelle 11b auf der Kontaktseite 6 der flexiblen Leiterplatte 5 ausgebildet. Diese ist durch ein in dem Zwischenraum 7 angeordnetes Verbindungsmittel 8, das elektrisch leitfähig ist, mit einer Kontaktierungsstelle 11a auf der zweiten Seite 4 der Grundleiterplatte 2 elektrisch leitend verbunden. Das Verbindungsmittel ist in diesem Ausführungsbeispiel als Lot ausgebildet, das stoffschlüssig an der auf der zweiten Seite 4 der der Grundleiterplatte 2 angeordneten Kontaktierungsstelle 11a und/oder an der auf der Kontaktseite 6 der flexiblen Leiterplatte 5 angeordneten weiteren Kontaktierungsstelle 11b anhaftet.

Außer dem Verbindungsmittel 8 ist in dem ersten Ausführungsbeispiel in dem Zwischenraum 7 zwischen der zweiten Seite 4 der Grundleiterplatte 2 und der Kontaktseite 6 der flexiblen Leiterplatte 5 eine fließfähige und aushärtbare Klebemasse 9 angeordnet. Diese fleißfähige und aushärtbare Klebemasse 9 umgibt in dem Zwischenraum 7 das Verbindungsmittel 8 umlaufend. Dabei haftet die fleißfähige und aushärtbare Klebemasse 9 beispielsweise im ausgehärteten Zustand vorzugsweise sowohl an der zweiten Seite 4 der Grundleiterplatte 2 als auch an der Kontaktseite 6 der flexiblen Leiterplatte 5 stoffschlüssig an. Die fleißfähige und aushärtbare Klebemasse 9 ist im nicht ausgehärteten Zustand beispielsweise niedrigviskos, so dass sie im nicht ausgehärteten Zustand einfach in den Zwischenraum 7 zwischen der zweiten Seite 4 der Grundleiterplatte 2 und die Kontaktseite 6 der flexiblen Leiterplatte 5 fließen kann und beispielsweise auch durch Kapilarkräfte beispielsweise auch in schwer zugängliche Bereiche im Zwischenraum 7 fließen kann. Nach Anordnung der fleißfähigen und aushärtbaren Klebemasse 9 in dem Zwischenraum 7 kann diese beispielsweise durch Erwärmung oder Belichtung ausgehärtet werden.

In diesem Ausführungsbeispiel ist die fließfähige und aushärtbare Klebemasse 9 teilweise aus einem Gießharz, insbesondere aus einem Epoxidgießharz gefertigt. Eine derartige fließfähige und aushärtbare Klebemasse 9 kann mit anderen zumindest teilweise aus Epoxidharz gefertigten Bauteilen besonders feste stoffschlüssige Verbindungen eingehen und beispielsweise besonders gut an diesen haften. So kann beispielsweise zwischen der fleißfähigen und aushärtbaren Klebemasse 9 und einer beispielsweise zumindest teilweise aus Epoxidharz gefertigten Grundleiterplatte 2 durch das gleiche Material eine stabile stoffschlüssige Verbindung hergestellt werden. Die beispielsweise zumindest teilweise aus Epoxidharz gefertigte fließfähige und aushärtbare Klebemasse 9 haftet an der zumindest teilweise aus Epoxidharz gefertigten flexiblen Leiterplatte 5 oder der zumindest teilweise aus Epoxidharz gefertigten Schutzschicht 16 oder Schutzfolie 17 anhaften.

Die in dieser Anmeldung aufgeführten Anwendungsbeispiele stellen die Erfindung exemplarisch für eine Grundleiterplatte 2 mit einer Leiterbahn 10a und eine flexible Leiterplatte 5 mit einer weiteren Leiterbahn 10b dar. Natürlich kann die Grundleiterplatte 2 auch mehrere Leiterbahnen 10a mit mehreren Kontaktierungstellen 11a umfassen, die mit mehreren auf der flexiblen Leiterplatte 5 ausgebildeten weiteren Kontaktierungsstellen 11b weiterer Leiterbahnen 10b durch mehrere in dem Zwischenraum 7 angeordnete Verbindungsmittel 8 elektrisch leitend verbunden sind.

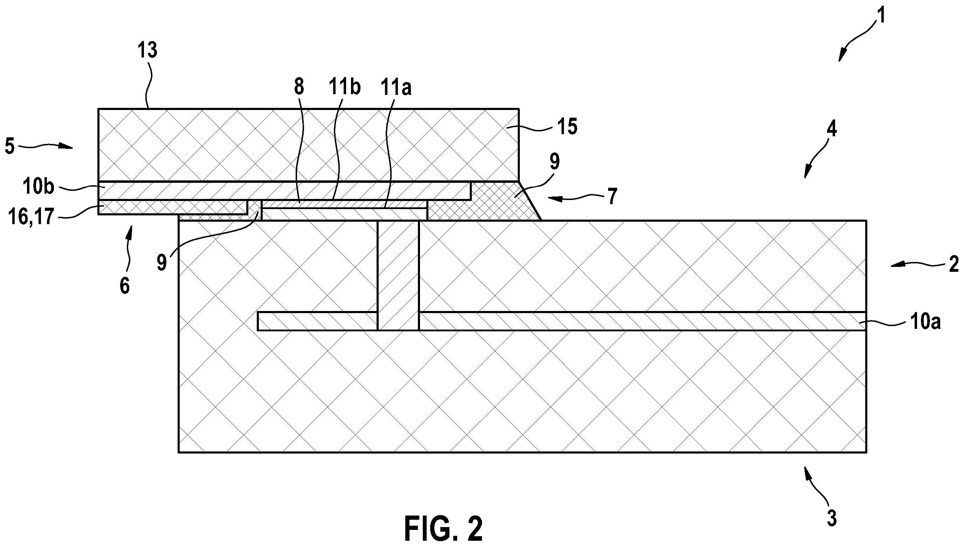

Fig. 2 zeigt einen Querschnitt durch ein zweites Ausführungsbeispiel der erfindungsgemäßen elektronischen Baugruppe 1. In diesem zweiten Ausführungsbeispiel umfasst die Leiterbahn 10a der Grundleiterplatte 2 im Unterschied zum ersten Ausführungsbeispiel nicht die Kontaktierungsstelle 11a. In dem zweiten Ausführungsbeispiel sind die Kontaktierungsstelle 11a und die Leiterbahn 10a zweistückig ausgebildet. Die Leiterbahn 10a ist dabei im Inneren der Grundleiterplatte 2 ausgebildet und die Kontaktierungsstelle 11a ist an der zweiten Seite 4 der Grundleiterplatte 2 ausgebildet. Die Leiterbahn 10a ist beispielsweise mit der auf der zweiten Seite 4 der Grundleiterplatte 2 angeordneten Kontaktierungsstelle 11a elektrisch leitend verbunden.

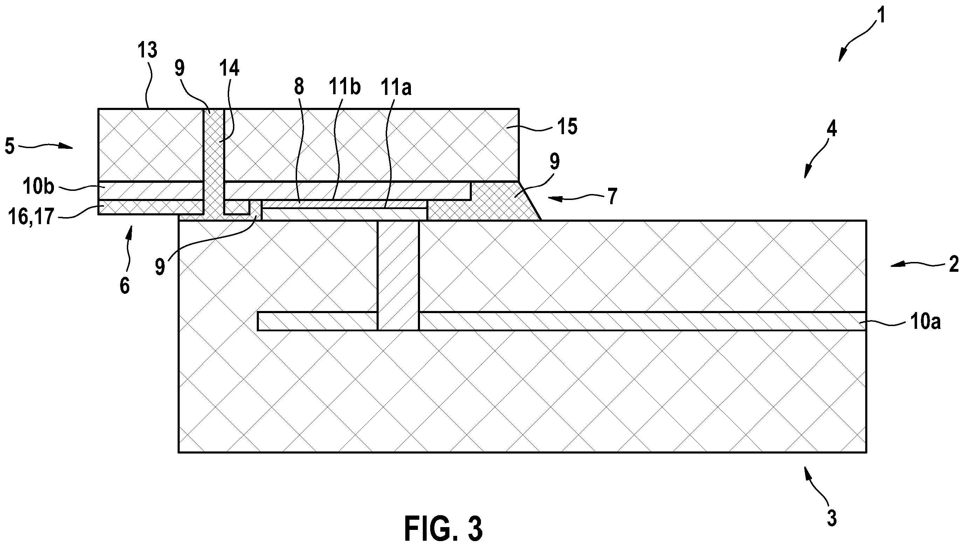

Fig. 3 zeigt einen Querschnitt durch ein drittes Ausführungsbeispiel der erfindungsgemäßen elektronischen Baugruppe. Im Unterschied zum ersten Ausführungsbeispiel und zum zweiten Ausführungsbeispiel ist in dem dritten Ausführungsbeispiel in der flexiblen Leiterplatte 5 ein Kanal 14 ausgebildet, der die Kontaktseite 6 der flexiblen Leiterplatte 5 im Bereich des Zwischenraums 7 mit einer von der Kontaktseite 6 abgewandten Außenseite 13 der flexiblen Leiterplatte 5 verbindet und der mit der fließfähigen und aushärtbaren Klebemasse 9 gefüllt ist. Der Kanal 14 durchbricht dabei in diesem Ausführungsbeispiel beispielsweise die flexible Basisfolie 15 der flexiblen Leiterplatte 5 und beispielsweise auch die Schutzschicht 16 und die Schutzfolie 17. Der Kanal 9 ist beispielsweise auch teilweise mit der fließfähigen und aushärtbaren Klebemasse 9 gefüllt. Der Kanal 14 kann beispielsweise an Stellen der flexiblen Leiterplatte 5 ausgebildet sein, an denen er beispielsweise auch an schwer zugänglichen Bereichen in dem Zwischenraum 7 die Kontaktseite 6 der flexiblen Leiterplatte 5 im Bereich des Zwischenraums 7 mit der von der Kontaktseite 6 abgewandten Außenseite 13 der flexiblen Leiterplatte 5 verbindet. Durch den Kanal 14 kann beispielsweise beim Aushärten der fließfähigen und aushärtbaren Klebemasse 9 entstehendes Gas entweichen. Der Kanal 14 kann aber auch beispielsweise zur optischen Kontrolle dienen, ob beispielsweise schwer zugängliche Bereiche im Zwischenraum 7 von der fließfähigen und aushärtbaren Klebemasse 9 gefüllt sind. Die fließfähige und aushärtbare Klebemasse 9 kann dabei beispielsweise durch Kapilarwirkung in dem Kanal 14 aufsteigen wodurch der Füllzustand sichtbar gemacht wird.

Zur Herstellung einer elektronischen Baugruppe 1, insbesondere für ein Getriebesteuermodul wird beispielsweise als erstes die Grundleiterplatte 2 und die flexible Leiterplatte bereitgestellt. Anschließend kann beispielsweise das elektrisch leitfähige Verbindungsmittel 8 auf der zweiten Seite 4 der Grundleiterplatte 2 oder auf der Kontaktseite 6 der flexiblen Leiterplatte 5 angeordntet werden, so dass das Verbindungsmittel 8 in elektrisch leitendem Kontakt mit der Kontaktierungsstelle 11a auf der zweiten Seite 4 der Grundleiterplatte 2 oder mit der weiteren Kontaktierungsstelle 11b der Kontaktseite 6 der flexiblen Leiterplatte 5 steht. Anschließend werden beispielsweise die Grundleiterplatte 2 und die flexible Leiterplatte 5 derart angeordnet, dass die zweite Seite 4 der Grundleiterplatte 2 der Kontaktseite 6 der flexiblen Leiterplatte 5 zugewandt ist und die Kontaktseite 6 der flexiblen Leiterplatte 5 zumindest abschnittsweise von der Grundleiterplatte 2 durch wenigstens den Zwischenraum 7 beabstandet ist, und dass die weitere Kontaktierungsstelle 11b auf der Kontaktseite 6 der flexiblen Leiterplatte 5 durch das in dem Zwischenraum 7 angeordnete Verbindungsmittel 8 mit der Kontaktierungsstelle 11a auf der zweiten Seite 4 der Grundleiterplatte 2 elektrisch leitend verbunden ist. Dabei wird zwischen dem Verbindungsmittel 8 und der auf der zweiten Seite 4 der Grundleiterplatte 2 angeordneten Kontaktierungsstelle 11a und zwischen dem Verbindungsmittel 8 und der auf der Kontaktseite 6 der flexiblen Leiterplatte 5 angeordneten weiteren Kontaktierungsstelle 11b eine stoffschlüssige Verbindung hergestellt. Das Verbindungsmittel 8 ist ein Lot. So kann die elektrisch leitende Verbindung zwischen der weiteren Kontaktierungsstelle 11b auf der Kontaktseite 6 der flexiblen Leiterplatte 5 mit der Kontaktierungsstelle 11a auf der zweiten Seite 4 der Grundleiterplatte 2 beispielsweise dadurch realisiert werden, dass die weitere Kontaktierungsstelle 11b mit der Kontaktierungsstelle 11a verlötet wird. Nach der Herstellung der elektrisch leitenden Verbindung zwischen der weiteren Kontaktierungsstelle 11b und der Kontaktierungsstelle 11a wird beispielsweise die fließfähige und aushärtbare Klebemasse 9 in dem Zwischenraum 7 zwischen der zweiten Seite 4 der Grundleiterplatte 2 und der Kontaktseite 6 der flexiblen Leiterplatte 5 eingebracht, so dass die fließfähige und aushärtbare Klebemasse 9 in dem Zwischenraum 7 das Verbindungsmittel 8 umlaufend umgibt und sowohl an der zweiten Seite 4 der Grundleiterplatte 2 als auch an der Kontaktseite 6 der flexiblen Leiterplatte 5 anhaftet. Anschließend wird die fließfähige und aushärtbare Klebemasse 9 ausgehärtet.

Selbstverständlich sind noch weitere Ausführungsbeispiele und Mischformen der dargestellten Ausführungsbeispiele möglich.

## Patentansprüche

1. Elektronische Baugruppe (1) für ein Getriebesteuermodul, umfassend eine Grundleiterplatte (2) mit einer ersten Seite (3) und einer von der ersten Seite (3) abgewandten zweiten Seite (4) und eine flexible Leiterplatte (5), die eine der zweiten Seite (4) der Grundleiterplatte (2) zugewandte Kontaktseite (6) aufweist,
wobei die Kontaktseite (6) der flexiblen Leiterplatte (5) zumindest abschnittsweise von der Grundleiterplatte (2) durch wenigstens einen Zwischenraum (7) beabstandet ist und wobei die Grundleiterplatte (2) wenigstens eine Leiterbahn (10a) aufweist und die flexible Leiterplatte (5) wenigstens eine weitere Leiterbahn (10b) aufweist und
auf der zweiten Seite (4) der Grundleiterplatte (2) eine elektrisch mit der wenigstens einen Leiterbahn (10a) verbundene Kontaktierungsstelle (11a) ausgebildet ist,
und auf der Kontaktseite (6) der flexiblen Leiterplatte (5) eine elektrisch mit der wenigstens einen weiteren Leiterbahn (10b) verbundene weitere Kontaktierungsstelle (11b) ausgebildet ist,
und die weitere Kontaktierungsstelle (11b) auf der Kontaktseite (6) der flexiblen Leiterplatte (5) durch ein in dem Zwischenraum (7) angeordnetes Verbindungsmittel (8), das elektrisch leitfähig ist, mit der Kontaktierungsstelle (11a) auf der zweiten Seite (4) der Grundleiterplatte (2) elektrisch leitend verbunden ist,
wobei in dem Zwischenraum (7) zwischen der zweiten Seite (4) der Grundleiterplatte (2) und der Kontaktseite (6) der flexiblen Leiterplatte (5) eine ausgehärtete, im ungehärteten Zustand
fließfähige und aushärtbare Klebemasse (9) angeordnet ist, die in dem Zwischenraum (7) das Verbindungsmittel (8) umlaufend umgibt und sowohl an der zweiten Seite (4) der Grundleiterplatte (2) als auch an der Kontaktseite (6) der flexiblen Leiterplatte (5) stoffschlüssig anhaftet,
wobei das Verbindungsmittel (8) stoffschlüssig an der auf der zweiten Seite (4) der Grundleiterplatte (2) angeordneten Kontaktierungsstelle (11a) und/oder an der auf der Kontaktseite (6) der flexiblen Leiterplatte (5) angeordneten weiteren Kontaktierungsstelle (11b) anhaftet, wobei das Verbindungsmittel (8) ein Lot ist,
wobei die flexible Leiterplatte (5) eine flexible Basisfolie (15), wenigstens eine auf der flexiblen Basisfolie (15) angeordnete weitere Leiterbahn (10b) und eine die wenigstens eine weitere Leiterbahn (10b) zumindest teilweise abdeckende Schutzschicht (16) oder Schutzfolie (17) umfasst, und dass die Klebemasse (9) zumindest bereichsweise stoffschlüssig an der flexiblen Basisfolie (15) anhaftet, wobei die fließfähige und aushärtbare Klebemasse (9) zumindest teilweise aus einem Epoxidgießharz gefertigt ist,
**dadurch gekennzeichnet, dass** die Basisfolie (15) ein Epoxidharz und Glasfasern aufweist und dass die die wenigstens eine Leiterbahn (10) zumindest teilweise abdeckende Schutzschicht (16) oder Schutzfolie (17) zumindest teilweise aus Epoxidharz hergestellt ist.

2. Elektronische Baugruppe nach einem der vorhergehenden Ansprüche, **dadurch gekennzeichnet, dass** die flexible Leiterplatte (5) zumindest in dem Bereich, in dem sie durch den Zwischenraum (7) von der Gundleiterplatte (2) beabstandet ist, planparallel zur Grundleiterplatte (2) angeordnet ist.

3. Elektronische Baugruppe nach einem der vorhergehenden Ansprüche, **dadurch gekennzeichnet, dass** in der flexiblen Leiterplatte (5) wenigstens ein Kanal (14) ausgebildet ist, der die Kontaktseite (6) der flexiblen Leiterplatte (5) im Bereich des Zwischenraums (7) mit einer von der Kontaktseite (6) abgewandten Außenseite (13) der flexiblen Leiterplatte (5) verbindet und der zumindest teilweise mit der Klebemasse (9) gefüllt ist.

## Claims

1. Electronic assembly (1) for a transmission control module, comprising a base circuit board (2) with a first side (3) and a second side (4) facing away from the first side (3) and comprising a flexible circuit board (5), which has a contact side (6) facing the second side (4) of the base circuit board (2),
wherein the contact side (6) of the flexible circuit board (5) is at least in sections spaced from the base circuit board (2) by at least one intermediate space (7) and wherein the base circuit board (2) has at least one conductor track (10a), and the flexible circuit board (5) has at least one further conductor track (10b) and a contact-making point (11a) electrically connected to the at least one conductor track (10a) is formed on the second side (4) of the base circuit board (2),
and a further contact-making point (11b) electrically connected to the at least one further conductor track (10b) is formed on the contact side (6) of the flexible circuit board (5),
and the further contact-making point (11b) on the contact side (6) of the flexible circuit board (5) is connected to the contact-making point (11a) on the second side (4) of the base circuit board (2) in an electrically conductive manner by means of a connection means (8), which is electrically conductive and arranged in the intermediate space (7),
wherein an adhesive compound (9), which is cured, can flow in the uncured state and can be cured, is arranged in the intermediate space (7) between the second side (4) of the base circuit board (2) and the contact side (6) of the flexible circuit board (5), said adhesive compound surrounding the periphery of the connection means (8) in the intermediate space (7) and is bonded to both the second side (4) of the base circuit board (2) and to the contact side (6) of the flexible circuit board (5) in a materially bonded manner,
wherein the connection means (8) is bonded to the contact-making point (11a) arranged on the second side (4) of the base circuit board (2) and/or to the further contact-making point (11b) arranged on the contact side (6) of the flexible circuit board (5) in a materially bonded manner, wherein the connection means (8) is a solder,
wherein the flexible circuit board (5) comprises a flexible base film (15), at least one further conductor track (10b) arranged on the flexible base film (15) and a protective layer (16) or protective film (17) at least partly covering the at least one further conductor track (10b), and the adhesive compound (9) is bonded at least in regions to the flexible base film (15) in a materially bonded manner, wherein the flowable and curable adhesive compound (9) is made at least partly from an epoxy casting resin,
**characterized in that** the base film (15) comprises an epoxy resin and glass fibres and **in that** the protective layer (16) or protective film (17) at least partly covering the at least one conductor track (10) is produced at least partly from epoxy resin.

2. Electronic assembly according to one of the preceding claims, **characterized in that** the flexible circuit board (5) is arranged plane-parallel to the base circuit board (2) at least in the region in which said flexible circuit board is spaced apart from the base circuit board (2) by the intermediate space (7).

3. Electronic assembly according to one of the preceding claims, **characterized in that** at least one channel (14) is formed in the flexible circuit board (5), said channel connecting the contact side (6) of the flexible circuit board (5) in the region of the intermediate space (7) to an outer side (13) of the flexible circuit board (5) facing away from the contact side (6) and being filled at least partly with the adhesive compound (9).

## Revendications

1. Ensemble électronique (1) pour un module de commande de transmission, comprenant une carte de circuits imprimés de base (2) dotée d'une première face (3) et d'une deuxième face (4) détournée de la première face (3), et une carte de circuits imprimés souple (5) qui présente une face de contact (6) tournée vers la deuxième face (4) de la carte de circuits imprimés de base (2),
dans lequel la face de contact (6) de la carte de circuits imprimés souple (5) est espacée au moins par endroits de la carte de circuits imprimés de base (2) par au moins un espace intermédiaire (7), et dans lequel la carte de circuits imprimés de base (2) présente au moins une piste conductrice (10a) et la carte de circuits imprimés souple (5) présente au moins une autre piste conductrice (10b), et sur la deuxième face (4) de la carte de circuits imprimés de base (2) est réalisé un point d'interconnexion (11a) relié électriquement à ladite au moins une piste conductrice (10a), et sur la face de contact (6) de la carte de circuits imprimés souple (5) est réalisé un autre point d'interconnexion (11b) relié électriquement à ladite au moins une autre piste conductrice (10b),
et l'autre point d'interconnexion (11b) sur la face de contact (6) de la carte de circuits imprimés souple (5) est relié de manière électriquement conductrice au point d'interconnexion (11a) sur la deuxième face (4) de la carte de circuits imprimés de base (2) par un moyen de liaison (8) disposé dans l'espace intermédiaire (7) et qui est électriquement conducteur,
dans lequel, dans l'espace intermédiaire (7) entre la deuxième face (4) de la carte de circuits imprimés de base (2) et la face de contact (6) de la carte de circuits imprimés souple (5), une substance adhésive durcie (9), coulante et durcissable à l'état non durci, est disposée qui entoure de manière périphérique, dans l'espace intermédiaire (7), le moyen de liaison (8), et adhère par liaison de matière à la fois à la deuxième face (4) de la carte de circuits imprimés de base (2) et à la face de contact (6) de la carte de circuits imprimés souple (5),
le moyen de liaison (8) adhérant par liaison de matière au point d'interconnexion (11a) disposé sur la deuxième face (4) de la carte de circuits imprimés de base (2) et/ou à l'autre point d'interconnexion (11b) disposé sur la face de contact (6) de la carte de circuits imprimés souple (5), le moyen de liaison (8) étant un métal d'apport,
la carte de circuits imprimés souple (5) comprenant un film de base souple (15), au moins une autre piste conductrice (10b) disposée sur le film de base souple (15) et une couche de protection (16) ou un film de protection (17) recouvrant au moins partiellement ladite au moins une autre piste conductrice (10b), et la substance adhésive (9) adhérant au moins par endroits par liaison de matière au film de base souple (15), la substance adhésive coulante et durcissable (9) étant fabriquée au moins en partie à partir d'une résine époxy de moulage,
**caractérisé en ce que** le film de base (15) présente une résine époxy et des fibres de verre, et **en ce que** la couche de protection (16) ou le film de protection (17) recouvrant au moins partiellement ladite au moins une piste conductrice (10) est fabriqué(e) au moins partiellement à partir d'une résine époxy.

2. Ensemble électronique selon l'une quelconque des revendications précédentes, **caractérisé en ce que** la carte de circuits imprimés souple (5) est espacée de manière plane et parallèle par rapport à la carte de circuits imprimés de base (2), au moins dans la zone dans laquelle elle est espacée de la carte de circuits imprimés de base (2) par l'espace intermédiaire (7).

3. Ensemble électronique selon l'une quelconque des revendications précédentes, **caractérisé en ce que** dans la carte de circuits imprimés souple (5), au moins un canal (14) est réalisé qui relie la face de contact (6) de la carte de circuits imprimés souple (5) au niveau de l'espace intermédiaire (7) à une face extérieure (13), détournée de la face de contact (6), de la carte de circuits imprimés souple (5), et qui est rempli au moins partiellement avec la substance adhésive (9).
